(19) Europäisches Patentamt
European Patent Office
Office européen des brevets

(11) **EP 1 113 446 B1**

(12) **EUROPEAN PATENT SPECIFICATION**

(45) Date of publication and mention
of the grant of the patent:
**16.07.2008   Bulletin 2008/29**

(51) Int Cl.:
***G11C 7/00*** *(2006.01)*

(21) Application number: **00128280.5**

(22) Date of filing: **22.12.2000**

(54) **Data reproduction device**

Gerät zur Wiedergabe von Daten

Appareil pour la reproduction de données

(84) Designated Contracting States:
**DE FR GB**

(30) Priority: **27.12.1999   JP 37032999**

(43) Date of publication of application:
**04.07.2001   Bulletin 2001/27**

(73) Proprietors:
• **SANYO ELECTRIC CO., LTD.**
  **Moriguchi-shi, Osaka (JP)**
• **Sanyo Technosound Co., Ltd.**
  **Daito-shi,**
  **Osaka (JP)**

(72) Inventors:
• **Sasaki, Tsutomu**
  **Shijonawate-shi,**
  **Osaka (JP)**
• **Matsumoto, Katsuyuki**
  **Hirakata-shi,**
  **Osaka (JP)**
• **Kamimura, Toru**
  **Sakata-gun,**
  **Shiga (JP)**

(74) Representative: **Glawe, Delfs, Moll**
  **Patentanwälte**
  **Postfach 26 01 62**
  **80058 München (DE)**

(56) References cited:
**US-A- 5 774 863**

**Description**

FIELD OF THE INVENTION

The present invention relates to data reproduction devices for reproducing data recorded on memory cards, and more particularly to data reproduction devices which are designed to reduce power consumption.

BACKGROUND OF THE INVENTION

Digital audio players are conventionally known to read compressed audio data on various signal memory media and to expand and reproduce the audio data in the memory media. With the players, the data is recorded / reproduced at the bit rate of about 128 K bps, to produce fine quality sound. On the other hand, the development of the digital technology in recent years provides various data storage media. Attention is directed to one of the media, IC memory card which is adapted to write and read data at the high bit rate, about a maximum of 8 Mbps.

Digital audio players having an IC memory card for use as a data storage medium are developed. In the digital audio players, data is written / read to IC memory card at the bit rate of about 128 Kbps in conformity with the bit rate for decoding which is satisfactory in respect of sound quality. The power consumption of the IC memory card is generally constant during memory access regardless of the difference in the bit rate for data writing / reading.

With the digital audio player having the IC memory card for use as the data storage medium, the use of a primary or a secondary battery as power source can realize its portability. However, the audio player of the portable type has the problem that the player is endurable to be used within the limited period of time since the primary or the secondary battery is limited in capacity.

Document US-A-5 940 352 discloses a data reproduction device comprising a control circuit for reading out data recorded on a a memory card. When reproduction of the designated track is finished, the device enters the standby state, and waits for designation of a track to be reproduced.

SUMMARY OF THE INVENTION

An object of the present invention is to provide a data reproduction device such as a digital audio player, etc. which has a memory card, and to prolong the period of time during which the player is endurable to be used by reducing its power consumption.

The present invention provides a data reproduction device as set out in claim 1. It comprises a control circuit for reading out data recorded on a memory card having a controller is mounted thereon, a data processing circuit for performing required processing to the read data and outputting the resulted data.

The controller of the memory card is so constructed that an active mode is set wherein data is read out under current consumption in a first current value in response to memory access of data reading, and thereafter a standby mode automatically follows to wait for next memory access under current consumption in a second current value which is lower than in the first current value.

Further, the control circuit comprises a buffer for temporarily storing data read out from the memory card, a first control means for reading out data from the memory card at a first bit rate and storing the data, a second control means for reading out data stored in the buffer at a second bit rate which is lower than the first rate and supplying the data to the data processing circuit.

With the data reproduction device of the invention, when a user manipulates to reproduce data, the control circuit repeats the operation to access to the memory card, and to read out intermittently predetermined amount of data from the memory card at the first bit rate. The read data is stored in the buffer.

In this operation, the controller of the memory card sets the active mode in response to the access from the control circuit to maintain the active mode until finishing reading out the predetermined amount of the data. In the active mode, the data is read out under the current consumption in the first current value. When finishing reading out the predetermined amount of the data, the controller sets the standby mode after, for example, lapse of the predetermined period of time, and to wait for the next memory access under the current consumption in the second current value.

The data stored in the buffer is read out at the second bit rate and supplied to the data processing circuit. This generates a given space area, causing the control circuit to gain access to the memory card again and to start reading out the data from the memory card.

The data, as described above, is intermittently read out from the memory card, stored temporarily in the buffer, thereafter read out from the buffer at the low bit rate, and supplied to the data processing circuit. This operation is repeated until all the data to be reproduced is read out from the memory card. Accordingly, either the active mode or the standby mode is alternatively set in the memory card, the current consumption in the standby mode is lower than in the active mode. The current consumption in the active mode is constant regardless of the difference of the bit rate at the data reading.

With the data reproduction device of the invention, as described, since power consumed by the memory card for reading out all the data to be reproduced is a total value of the power consumption in the active mode and that in the standby mode, the power consumption is more reduced than in the conventional case where the memory card is always accessed at the low bit rate which does not have a problem in data reproduction, to continue great current consumption.

BRIEF DESCRIPTION OF THE INVENTION

FIG. 1 is a block diagram showing the construction of a digital audio player embodying the invention;
FIG. 2 is a flow chart showing data reproduction control with the digital audio player; and
FIG. 3 is a time chart showing mode transition of a memory card.

DETAILED DESCRIPTION OF EMBODIMENT

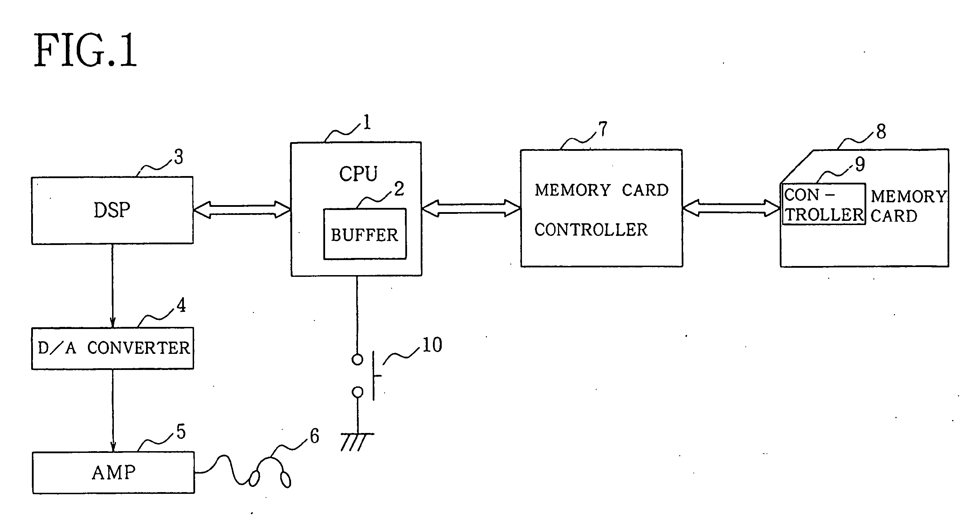

A digital audio player embodying the present invention will be described below in detail with reference to the drawings. FIG. 1 shows that the digital audio player of the invention can be loaded with a memory card 8 having a controller 9 mounted thereon. The audio player comprises a memory card controller 7 to control write / read of data to the memory card 8, a CPU 1 to execute various controlling operation like data reproducing in response to user's manipulation, a digital signal processing circuit DSP 3 to perform processing required for reproduction like decoding, etc. on audio data read out from the memory card 8, a D/A converter 4 to convert digital audio signal obtained from the DSP 3 into analog audio signal, an amplifier 5 to amplify the audio signal obtained from the D/A converter 4 and to output the signal to a headphone 6. The CPU 1 has a buffer 2 incorporated therein, and is connected to a manipulating key 10 for a user giving the device a command for various operation.

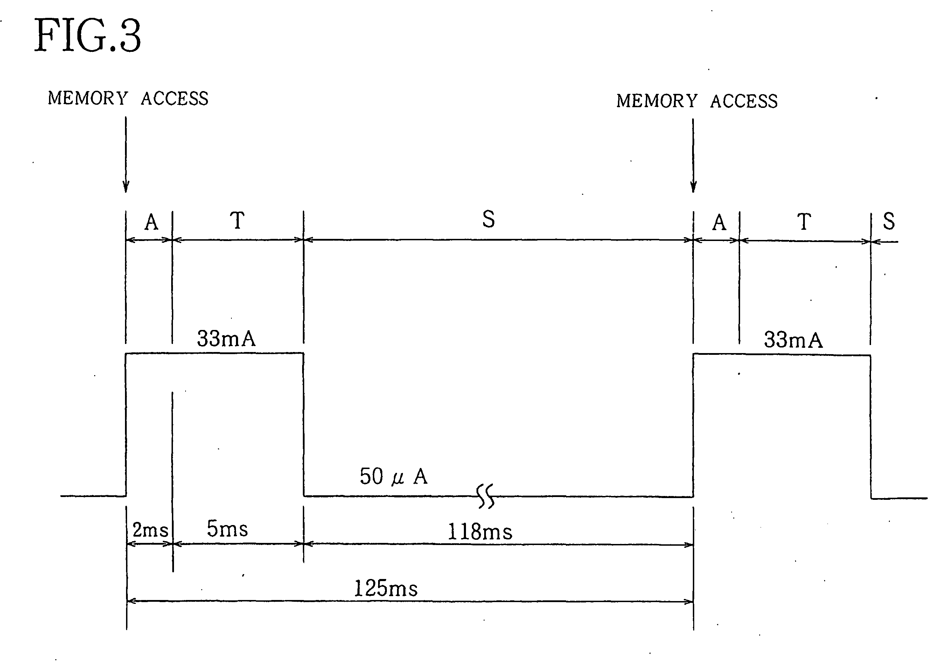

The controller 9 mounted on the memory card 8, as shown in FIG. 3, sets an active mode A to read out data under the current consumption of 33mA in response to memory access of data reading. If there is no memory access within predetermined period of time T, a standby mode S automatically follows to wait for next memory access under the current consumption of 50 $\mu$A.

In the embodiment, a power source voltage of the memory card 8 is set to 3V, a maximum bit rate is 8 Mbps at the data reading, and transition period of time T is 5 ms from the active mode to the standby mode.

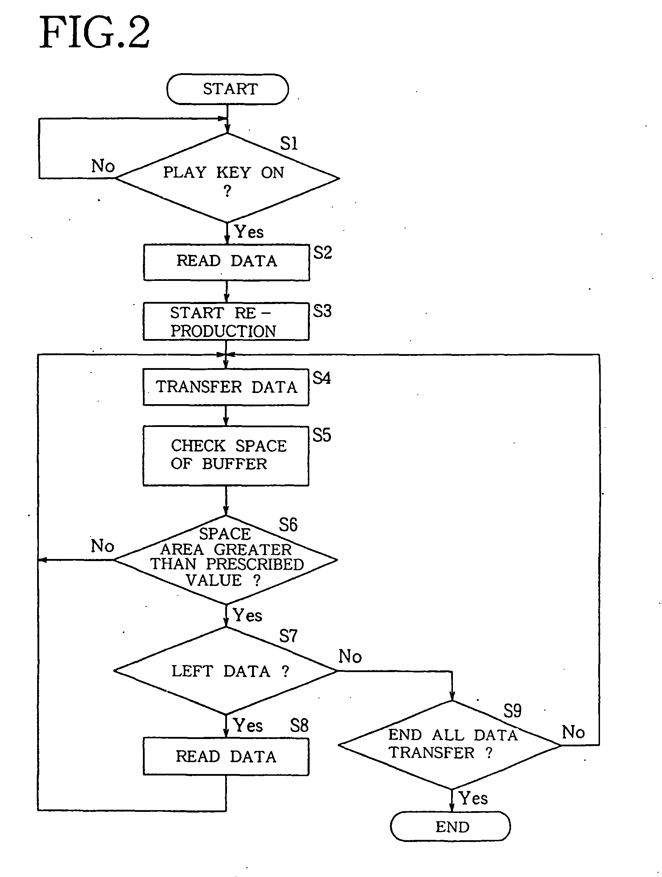

FIG. 2 shows controlling procedure which the CPU 1 executes in data reproduction. An inquiry is made in step S1 as to whether PLAY key is turned on by user's manipulation. When PLAY key is on, the CPU 1 commands the memory card controller 7 to read the data from the memory card 8 in step S2. This sets the memory card 8 in the active mode, to read the predetermined amount of data from the memory card 8 at the bit rate of 8 Mbps. When reading data access (active mode) from the memory card ends and the predetermined period of time T (=5 ms) elapses, the memory card 8 is into the standby mode.

The data read from the memory card 8 is temporarily stored in the buffer 2, and thereafter is read out from the buffer 2 at the bit rate of 128 Kbps. Subsequently, DSP 3 is given a command to start the reproduction operation in step S3.

Next in step S4, the CPU starts transferring data read out from the buffer 2 to the DSP 3. As a result, the data is given processing including decoding and the like required for reproduction by the DSP 3, and is D/A converted by the D/A converter to start the audio reproduction.

In step S5 the space of the buffer 2 is checked, and an inquiry is made in step S6 as to whether space area of the buffer is greater than the prescribed value. When the answer is No, step S4 follows again to continue the data transfer. This expands the space area of the buffer 2 gradually.

When the answer is Yes in step S6, step S7 follows. In step S7 an inquiry is made as to whether the data to be read out is left on the memory card 8. When the answer is Yes, step S8 follows to re-read the predetermined amount of data from the memory card 8. Step S4, thereafter, follows again to continue the data transfer to the DSP 3.

On the other hand, when the answer is No, in step S7, Step S9 follows to give an inquiry as to whether all the data transfer is ended. When the answer is No, Step S4 follows again to repeat the data transfer. When the answer is Yes, the procedure ends.

The execution of the above procedure sets the active mode A or the standby mode S alternatively, to read out the data from the memory card 8 intermittently. This causes the data written on the buffer 2 of the CPU 1 to be read out successively, supplying the data to the DSP 3.

For example, in the case where the capacity of the buffer 2 of the CPU 1 is 16 Kbit, and the decoding bit rate of the audio data by the DSP 3 is 128 Kbps, as shown in FIG. 3, the data is reproduced by the repetition of data reading out period of 2 ms wherein the data is read from the memory card 8 in the active mode, transit period to the standby mode of 5 ms, and reading sleep period of 118 ms in the standby mode. The mean consumed current I is 1.9 mA calculated from the following Mathematical Expression 1.

(Mathematical Expression 1)

$$I = (2 \text{ ms} \times 33 \text{ mA} + 5 \text{ ms} \times 33 \text{ mA} + 118 \text{ ms} \times 50 \text{ } \mu\text{A}) / 125 \text{ ms}$$

$$= 1.9 \text{ mA}$$

If data is successively read out from a memory card at the bit rate of 128 Kbps as conventionally in place of the intermittent reading method of the memory card according to the embodiment, the consumed current is 33 mA in constant, so that the power consumption is minimized to 1 / 17 or less according to the invention. The increase of the capacity of the buffer 2 of the CPU 1 provides greater effect.

The present invention described is particularly effective to the data reproduction device of the portable type since the intermittent data read out from the memory card enables the device to reduce the power consumption greatly.

The invention can be practiced not only for digital audio players but also for digital video devices such as digital cameras, etc.

**Claims**

1.  A data reproduction device comprising:

    a control circuit for reading out data recorded on a memory card (8), the memory card (8) having a controller (9) mounted thereon, and
    a data processing circuit (3 - 5) for giving required processing to the read data and outputting the generated data, the data reproduction device being *characterized* **in that**
    the controller (9) of the memory card (8) is so constructed that an active mode (A) is set for reading out the data under a current consumption of a first current value in response to memory access of data reading and thereafter automatically follows to a standby mode (5) for waiting for next memory access under a current consumption of a second current value lower than the first current value, the control circuit comprises a buffer (2) for temporarily storing the data to be read out from the memory card (8), first control means (7) to read out the data from the memory card (8) at a first bit rate to store the generated data to the buffer (2), and second control means (1) to read out the data stored in the buffer (2) at a second bit rate lower than the first bit rate to supply the read data to the data processing circuit (3 - 5), and while a predetermined amount of data is intermittently read out from the memory card (8) at a first bit rate and stored in the buffer (2) according to the first control means (7), the data is read out from the buffer (2) at a second bit rate according to the second control mean (1),
    that the first control means (7) starts reading new data when predetermined space capacity is generated in the buffer (2) by the second control means (1) reading out the data from the buffer and
    that the controller (9) of the memory card (8) is so constructed that the standby mode (5) follows when there is no memory access within a predetermined period (T) of time after setting the active mode (A).

2.  A data reproduction device according to claim 1 wherein the control circuit repeats the intermittent read-out using the buffer (2) until all the data to be reproduced is read out from the memory card (8).

**Patentansprüche**

1.  Datenwiedergabegerät, mit:

    einer Steuerschaltung zum Auslesen von Daten, die auf einer Speicherkarte (8) aufgezeichnet sind, wobei auf der Speicherkarte (8) eine Steuerung (9) montiert ist, und
    einer Datenverarbeitungsschaltung (3-5), um den ausgelesenen Daten die erforderliche Verarbeitung zu geben und die erzeugten Daten auszugeben,

wobei die Datenwiedergabevorrichtung **dadurch gekennzeichnet ist, dass**

die Steuerung (9) der Speicherkarte (8) so konstruiert ist, dass ein Aktivmodus (A) gesetzt wird, um Daten mit einem Stromverbrauch mit einem ersten Stromwert in Antwort auf den Speicherzugriff des Datenauslesens, auszulesen, und danach automatisch ein Stand-by-Modus (5) folgt, um auf den nächsten Speicherzugriff mit einem Stromverbrauch mit einem zweiten Stromwert niedriger als dem ersten Stromwert zu warten, wobei die Steuerschaltung aufweist einen Puffer (2) zum temporären Speichern der aus der Speicherkarte (8) auszulesenden Daten, erste Steuermittel (7) zum Auslesen der Daten aus der Speicherkarte (8) mit einer ersten Bitrate, um die erzeugten Daten in den Puffer (2) zu speichern, und zweite Steuermittel (1) zum Auslesen der in dem Puffer (2) gespeicherten Daten mit einer zweiten Bitrate niedriger als der ersten Bitrate, um die ausgelesenen Daten der Datenverarbeitungsschaltung (3-5) zuzuleiten, und während eine vorbestimmte Datenmenge intermittierend aus der Speicherkarte (8) mit einer ersten Bitrate ausgelesen und in dem Puffer (2) gemäß den ersten Steuermitteln (7) gespeichert wird, werden Daten aus dem Puffer (2) mit einer zweiten Bitrate gemäß den zweiten Steuermitteln (1) ausgelesen,

dass die ersten Steuermittel (7) das Auslesen neuer Daten dann starten, wenn eine vorbestimmte Raumkapazität in dem Puffer (2) durch die zweiten Steuermittel (1) durch Auslesen der Daten aus dem Puffer erzeugt worden ist, und

dass die Steuerung (9) der Speicherkarte (8) so konstruiert ist, dass der Stand-by-Modus (5) folgt, wenn innerhalb einer vorbestimmten Zeitspanne (T) nach dem Setzen des Aktivmodus (A) kein Speicherzugriff erfolgt.

**2.** Datenwiedergabevorrichtung nach Anspruch 1, wobei die Steuerschaltung das intermittierende Auslesen unter Verwendung des Puffers (2) so lange wiederholt, bis alle wiederzugebende Daten aus der Speicherkarte (8) ausgelesen worden sind.

## Revendications

**1.** Dispositif de reproduction de données comprenant :

un circuit de commande pour lire des données enregistrées dans une carte de mémoire (8), la carte de mémoire (8) ayant un contrôleur (9) monté sur celle-ci, et

un circuit de traitement de données (3-5) pour effectuer un traitement nécessaire sur les données lues et délivrer en sortie les données générées,

le dispositif de reproduction de données étant **caractérisé en ce que**

le contrôleur (9) de la carte de mémoire (8) est réalisé de manière qu'un mode actif (A) soit établi pour lire les données avec une consommation de courant d'une première valeur de courant en réponse à un accès à la mémoire de lecture de données et suive ensuite automatiquement un mode d'attente (5) pour attendre un accès suivant à la mémoire avec une consommation de courant d'une seconde valeur de courant inférieure à la première valeur de courant, le circuit de commande comprend une mémoire tampon (2) pour stocker provisoirement les données à lire à partir de la carte de mémoire (8), des premiers moyens de commande (7) pour lire les données à partir de la carte de mémoire (8) à un premier débit binaire pour mémoriser les données générées dans la mémoire tampon (2), et des deuxièmes moyens de commande (1) pour lire les données mémorisées dans la mémoire tampon (2) à un deuxième débit binaire inférieur au premier débit binaire pour délivrer les données lues au circuit de traitement de données (3-5), et, alors qu'une quantité de données prédéterminée est lue de manière intermittente à partir de la carte de mémoire (8) à un premier débit binaire et mémorisée dans la mémoire tampon (2) selon les premiers moyens de commande (7), les données sont lues à partir de la mémoire tampon (2) à un deuxième débit binaire selon les deuxièmes moyens de commande (1),

**en ce que** les premiers moyens de commande (7) commencent la lecture de nouvelles données quand une capacité d'espace prédéterminée est générée dans la mémoire tampon (2) par les deuxièmes moyens de commande (1) lisant les données à partir de la mémoire tampon et

**en ce que** le contrôleur (9) de la carte de mémoire (8) est réalisé de manière qu'un mode d'attente (5) suive quand il n'existe aucun accès à la mémoire dans une période de temps prédéterminée (T) après l'établissement du mode actif (A).

**2.** Dispositif de reproduction de données selon la revendication 1, dans lequel le circuit de commande répète la lecture intermittente en utilisant la mémoire tampon (2) jusqu'à ce que toutes les données à reproduire soient lues à partir de la carte de mémoire (8).

# FIG.1

EP 1 113 446 B1

# FIG.2

```
              ┌──────────┐
              │  START   │
              └──────────┘
                   │
          ┌────────▼────────┐  S1
     No  ╱   PLAY KEY ON     ╲
    ◄───◄         ?           ╲
         ╲                    ╱
          └────────┬────────┘
                   │ Yes
              ┌────▼─────┐ S2
              │ READ DATA │
              └────┬─────┘
                   │
              ┌────▼──────┐ S3
              │ START RE- │
              │ PRODUCTION│
              └────┬──────┘
                   │
              ┌────▼──────┐ S4
              │TRANSFER DATA│
              └────┬──────┘
                   │
              ┌────▼──────┐ S5
              │CHECK SPACE│
              │ OF BUFFER │
              └────┬──────┘
                   │
          ┌────────▼────────┐ S6
     No  ╱     SPACE         ╲
    ◄───◄  AREA GREATER       ╲
         ╲ THAN PRESCRIBED    ╱
          ╲    VALUE ?       ╱
          └────────┬────────┘
                   │ Yes
          ┌────────▼────────┐ S7            No
         ╱    LEFT DATA ?    ╲ ─────────────┐
         ╲                   ╱              │
          └────────┬────────┘               │
                   │ Yes   S8               │
              ┌────▼──────┐        ┌────────▼────────┐ S9
              │ READ DATA │       ╱  END ALL DATA     ╲  No
              └───────────┘       ╲   TRANSFER ?      ╱───
                                   └────────┬────────┘
                                            │ Yes
                                       ┌────▼─────┐
                                       │   END    │
                                       └──────────┘
```

# FIG.3

EP 1 113 446 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5940352 A